# FASCICULE DE BREVET EUROPEEN

(11) **EP 0 447 317 B1**
(45) Date de publication et mention de la délivrance du brevet: **15.03.1995**
(21) Numéro de dépôt: 91400682.0
(22) Date de dépôt: 13.03.1991
(51) Int. Cl.: C04B 35/52, C04B 35/80, C23C 16/04

(54) **Procédé de formation d'une ligne de pliage ou de séparation lors de la fabrication d'une pièce en matériau composite**
Verfahren zur Ausbildung einer Falt- oder Trennlinie während der Herstellung eines Verbundwerkstoffteils
Method of forming a fold or separation line during the fabrication of a composite material part

(30) Priorité: 15.03.1990 FR 9003347
(43) Date de publication de la demande: 18.09.1991
(73) Titulaire: SOCIETE EUROPEENNE DE PROPULSION, 92150 Suresnes (FR)
(72) Inventeur: Barbaza, François R., F-33250 Pauillac (FR)
(74) Mandataire: Joly, Jean-Jacques

(56) Documents cités:
- WO-A-88/10245

## Description

La présente invention concerne la fabrication de pièces en matériau composite.

Plus particulièrement, la présente invention concerne la fabrication de pièces de structure comprenant l'élaboration d'une préforme fibreuse, ayant sensiblement la forme de la pièce à réaliser, et la densification de la préforme par une matrice obtenue par infiltration chimique en phase vapeur au sein de la porosité de la préforme. Cette technique est bien connue, notamment pour la fabrication de pièces en matériaux composites thermostructuraux tels que les composites carbone-carbone et les composites à matrice céramique.

La préforme fibreuse est réalisée à partir de textures fibreuses, telles que des fils, tissus, voiles de fibres, feutres, nappes de fibres. Ces textures peuvent être bobinées ou disposées en strates superposées. Dans ce dernier cas, les strates peuvent être liées entre elles par aiguilletage ou implantation de fils.

Après son élaboration, la préforme est généralement placée dans un outillage afin d'être densifiée par infiltration chimique en phase vapeur. L'outillage, habituellement en graphite, a pour fonction de maintenir la préforme dans la forme voulue, tout en assurant, le cas échéant, un compactage de la préforme afin d'obtenir le taux volumique de fibres désiré (pourcentage du volume apparent de la préforme effectivement occupé par les fibres).

Lorsque la densification de la préforme est suffisante pour que la consolidation de celle-ci soit effective, la préforme peut être retirée de l'outillage avant de poursuivre l'infiltration en phase vapeur jusqu'à atteindre le degré de densification souhaite.

Pour la réalisation de certaines pièces, en particulier des disques de frein, il est proposé dans le document WO-A-8810245 de former des trous à travers la préforme afin de faciliter l'accès des gaz au coeur de la préforme pendant l'infiltration chimique en phase vapeur. Afin d'obtenir dans la pièce finie des trous à bords nets, des tiges métalliques sont introduites et laissées en place dans les trous de la préforme pendant un éventuel traitement thermique précédant la densification et/ou pendant une phase initiale de densification, celle-ci étant achevée après retrait des tiges.

Des problèmes difficiles ou coûteux à résoudre sont rencontrés lorsque les pièces à réaliser sont de forme complexe.

Pour des pièces de grandes dimensions, une technique connue consiste à réaliser séparément différentes parties d'une pièce à fabriquer puis à assembler ces parties. Les différentes parties peuvent être réalisées simplement au stade de la consolidation, c'est-à-dire incomplètement densifiees. La pièces est alors obtenue par assemblage de ses parties constitutives et co-infiltration de celles-ci pour atteindre le niveau de densification voulu. La matrice co-infiltrée au sein des différentes parties réalise un "collage" de celles-ci du fait de sa continuité aux interfaces entre ces parties. Un procédé de ce type, avec interposition d'un joint de colle entre les pièces à assembler est décrit dans le document EP-A-0 051 535.

Cette technique nécessite donc la réalisation séparée de plusieurs parties constitutives de la pièce. En outre, la liaison entre ces parties dans la pièce terminée peut s'avérer insuffisante

Pour des pièces de forme complexe de petites dimensions, il est nécessaire de recourir à des outillages spécifiques et/ou de procéder à un usinage substantiel des pieces densifiées, ce qui alourdit considérablement le coût.

On notera encore que les techniques connues évoquées ci-avant ne permettent pas d'obtenir des pièces en matériau composite ayant une liaison souple intégrée, c'est-à-dire des pièces déformables.

La présente invention vise à remédier aux inconvénients précités en proposant un procédé permettant la formation d'une ligne de pliage ou de séparation lors de la fabrication d'une pièce en matériau composite.

Plus précisément, le procédé conforme à l'invention est caractérisé par le fait que l'on réalise sur la préforme un masquage le long de la ou chaque ligne de pliage ou de séparation afin de s'opposer à l'infiltration du matériau constitutif de la matrice dans la ou chaque zone masquée de la préforme, de sorte qu'après densification la ou chaque zone masquée de la préforme constitue une liaison souple intégrée à la préforme densifiée.

Le masquage de la ou chaque zone de la préforme peut être maintenu jusqu'à ce que le degré de densification final soit atteint, de manière à obtenir une pièce en matériau composite avec une ou plusieurs liaisons souples intégrées constituant une ou plusieurs lignes d'articulation.

Le masquage de la ou chaque zone de la préforme peut au contraire être supprimé après densification partielle ou consolidation des parties non masquées de la préforme. La ou les zones masquées constituent alors des liaisons souples qui autorisent le pliage de la préforme pour amener celle-ci à une forme correspondant à celle de la pièce à réaliser l'infiltration de la préforme est alors poursuivie jusqu'à atteindre le degré de densification final souhaité, ce qui rigidifie les liaisons du fait de la co-infiltration de celles-ci et des parties préalablement consolidées.

Le procédé conforme à l'invention peut encore trouver une application pour fabriquer plusieurs pièces à partir d'une seule préforme, les liaisons souples étant formées le long de lignes de séparation entre les parties de la préforme correspondant aux différentes pièces lors de la densification, les liaisons souples confèrent à la préforme la capacité de déformation nécessaire pour maintenir les différentes parties de celle-ci sur un conformateur. Après densification, des découpes sont réalisées le long des lignes de séparation pour obtenir les différentes pièces.

L'invention sera mieux comprise à la lecture de la description faite ci-après, a titre indicatif mais non limitatif, en référence aux dessins annexés sur lesquels :
- la figure 1 illustre très schématiquement un premier mode de réalisation d'un masquage partiel d'une préforme pour la mise en oeuvre du procédé selon l'invention ;
- la figure 2 illustre très schématiquement un autre mode de réalisation d'un masquage ;
- les figures 3A et 3B illustrent des étapes successives d'un mode de mise en oeuvre du procédé selon l'invention dans une première application de celui-ci ;
- les figures 4A à 4C illustrent des étapes successives d'un deuxième mode de mise en oeuvre du procédé selon l'invention dans une deuxième application de celui-ci ; et
- les figures 5A et 5B illustrent un troisième mode de mise en oeuvre du procédé selon l'invention dans une troisième application de celui-ci.

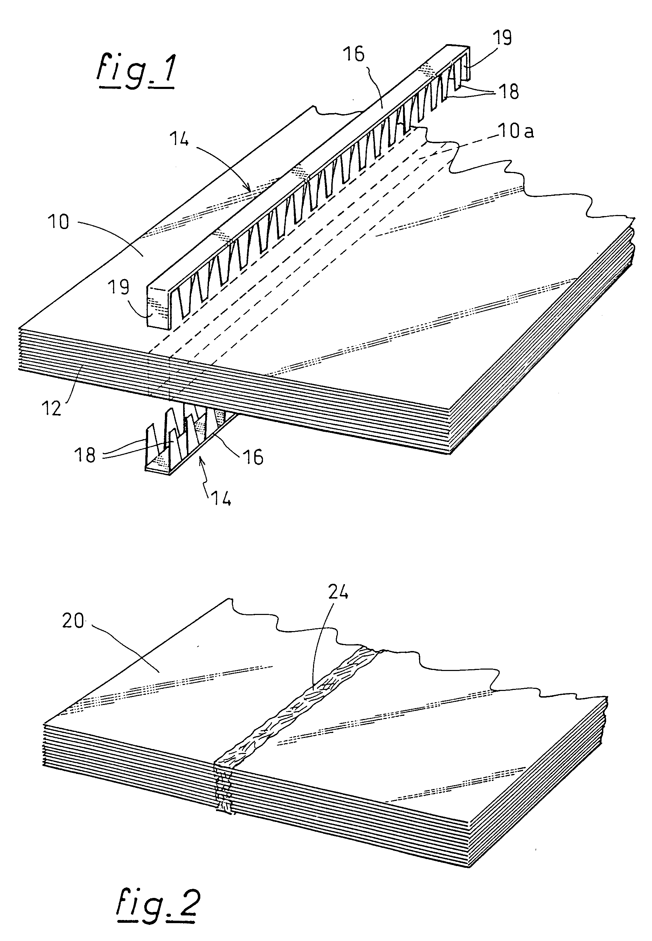

La figure 1 illustre une préforme 10 destinée à la fabrication d'une pièce en matériau composite. Dans cet exemple, la préforme 10 est formée par empilement à plat de strates 12 d'une texture fibreuse bidimensionnelle. Cette texture peut être notamment constituée par un tissu ou une nappe de fils, ou encore par un complexe formé par une couche de tissu ou une nappe de fils préaiguilletée avec un voile de fibres. Une liaison entre les strates 12 peut être réalisée par implantation de fils à travers les strates superposées ou par aiguilletage de celles-ci.

Une ligne de pliage ou de séparation est réservée sur la préforme par masquage d'une zone de celle-ci correspondant à la ligne de pliage ou de séparation à former.

Dans l'exemple illustré par la figure 1, le masquage est réalisé au moyen de deux caches 14 en forme de peignes ou brosses appliqués en regard l'un de l'autre sur les deux faces opposées de la préforme, le long de l'emplacement de la ligne de pliage ou de séparation à réserver.

Chaque cache 14 comprend une partie en forme de bande 16 dont la largeur correspond à celle de la ligne à former et qui est appliquée contre une face de la préforme 10. Du côté où elle est en contact avec la préforme, la bande 16 est munie de dents 18 dont la longueur est égale ou pratiquement égale à l'épaisseur de la préforme. Les dents 18 d'un cache pénètrent dans la préforme et se logent chacune entre deux dents de l'autre cache. A chacune de ses extrémités, l'un au moins des caches 14 présente un rebord 19 destiné à être appliqué contre le côté correspondant de la préforme 10. De la sorte, les bandes 16 et les dents 18 délimitent un volume pratiquement fermé 10a à l'intérieur de la préforme 10.

Lors de la densification de la préforme par infiltration chimique en phase vapeur, le volume 10a est inaccessible, ou quasiment inaccessible au flux gazeux d'infiltration, empêchant la densification du volume 10a de la préforme.

Lorsque les caches 14 sont retirés après densification, ou au moins après consolidation de la préforme, ils laissent entre les parties densifiées et rigidifiées de la préforme une zone non densifiée 10a constituant une liaison souple intégrée à la préforme.

Les caches 14 sont en un matériau résistant à l'agressivité du flux gazeux utilisé pour l'infiltration chimique en phase vapeur et à la température à laquelle l'infiltration est réalisée. Le matériau constitutif des caches 14 est par exemple le graphite ou le molybdène.

Le maintien en place des caches 14 est assuré par le simple engagement des dents 18 dans la préforme fibreuse. Si nécessaire, les caches 14 pourront être reliés l'un à l'autre, à leurs extrémités, par des brides réalisées dans le même matériau.

La figure 2 illustre une préforme 20 analogue à la préforme 10 de là figure 1 sur laquelle une ligne de pliage ou de séparation est réservée par dépôt local d'un matériau de masquage à l'emplacement de cette ligne. Le dépôt en forme de bande 24 est effectué de chaque côté de la préforme 20.

Le matériau constitutif des depôts 24 est choisi parmi les matériaux compatibles avec les conditions d' infiltration chimique en phase vapeur et susceptibles d'être ultérieurement éliminés sans dommage pour la pièce en matériau composite obtenue. Lorsque le matériau composite est de type thermostructural avec une préforme et une matrice en carbone ou en céramique, les masques 24 peuvent être réalisés en molybdène, lequel peut être éliminé par voie chimique, notamment par dissolution dans un bain d'acide tel que l'acide fluorhydrique.

Les masques 24 sont formés par fusion d'un fil ou d'une bande de molybdène. De la sorte, le molybdène se dépose non seulement en surface de la préforme 10, mais aussi s'infiltre à l'intérieur de celle-ci. Après densification et élimination du molybdène, on dispose ainsi d'une liaison souple intégrée à la préforme densifiée.

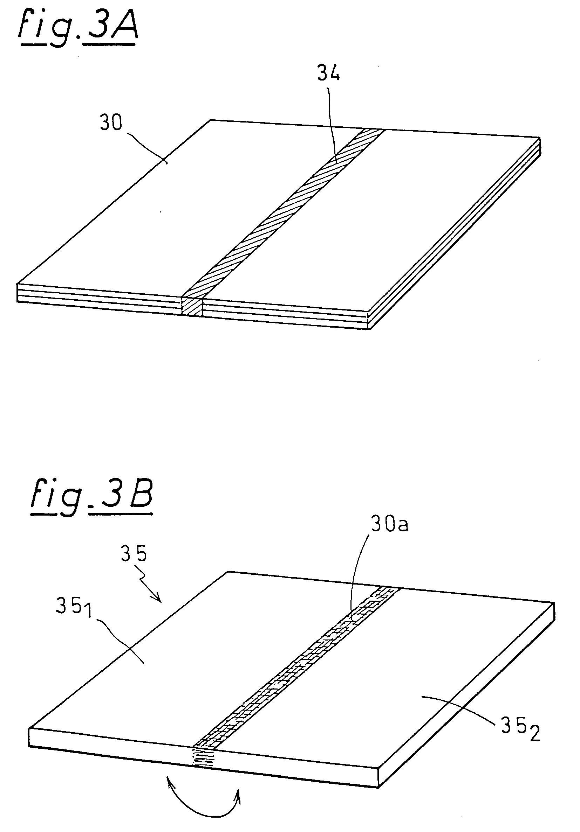

Les figures 3A et 3B illustrent l'utilisation du procédé conforme à l'invention pour réaliser une pièce en matériau composite constituée de deux parties articulées l'une par rapport à l'autre.

Une préforme fibreuse 30 constituée par un empilement de strates à plat est munie d'un masque 34 à l'emplacement de l'articulation à ménager dans la pièce finale (figure 3A).

La préforme 30 est ensuite densifiée par infiltration chimique en phase vapeur, jusqu'à atteindre le degré de densification souhaité. Au cours d'une première phase de densification, la préforme 30 est le cas échéant maintenue dans un outillage qui peut être simplement constitué de deux plateaux entre lesquels la préforme est enserrée.

Après la fin de la densification, le masque 34 est retiré, laissant une liaison souple 30a intégrée à la pièce 35 obtenue. La liaison 30a constitue une articulation entre les deux parties densifiées 35₁, 35₂ situées de part et d'autre de celle-ci.

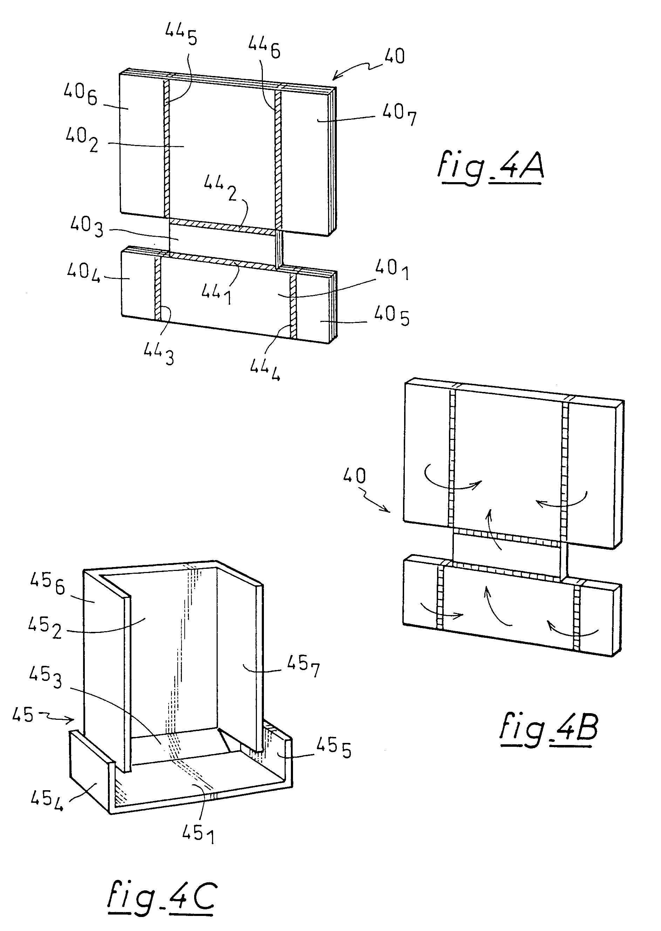

Les figures 4A à 4C illustrent l'utilisation du procédé conforme à l'invention pour la réalisation d'une pièce en matériau composite de forme complexe et de dimensions relativement grandes, en l'espèce une carcasse de siège d'hélicoptère en matériau composite à matrice céramique procurant une protection contre les projectiles, éventuellement en association avec d'autres revêtements.

La préforme fibreuse 40 (figure 4A) est constituée par un empilement de strates à plat découpées pour présenter la forme du siège 45 (figure 4C) développé à plat. On retrouve dans la préforme 40 les parties 40₁ à 40₇ qui correspondent au siège proprement dit 45₁, au dossier 45₂, à la partie de liaison 45₃ entre le siège et le dossier, à des panneaux latéraux 45₄ et 45₅ au niveau du siège et à des panneaux latéraux 45₆, 45₇ au niveau du dossier.

Des masques 44₁ à 44₆ sont disposés sur la préforme 40 au niveau des lignes délimitant les différentes parties de celles-ci, et une première phase d'infiltration en phase vapeur de la préforme est réalisée de manière à consolider ces différentes parties. La préforme peut être maintenue dans un outillage lors de cette phase de consolidation et en être retirée à la fin de la consolidation. L'outillage peut simplement consister en deux plateaux entre lesquels la préforme est enserrée.

Les masques 44₁ à 44₆ sont ensuite retirés, laissant des liaisons souples entre les parties consolidées de la préforme. Grâce à ces liaisons souples formant des lignes de pliage, la préforme 40 est pliée pour être amenée dans une forme correspondant à celle du siège à réaliser (figure 4B).

L'infiltration en phase vapeur est alors poursuivie, ce qui provoque la densification et la rigidification des liaisons souples et termine la densification des parties du siège 45 (figure 4C). Lors de cette densification finale, au moins jusqu'à consolidation des liaisons souples, un maintien des différentes parties du siège dans les positions qu'elles occupent après pliage peut être assuré au moyen d'un outillage. Celui-ci peut à l'évidence être beaucoup plus léger que celui qui serait nécessaire si les différentes parties du siège n'étaient pas consolidées. Compte tenu du coût élevé des outillages en graphite, le procédé selon l'invention permet donc une substantielle économie.

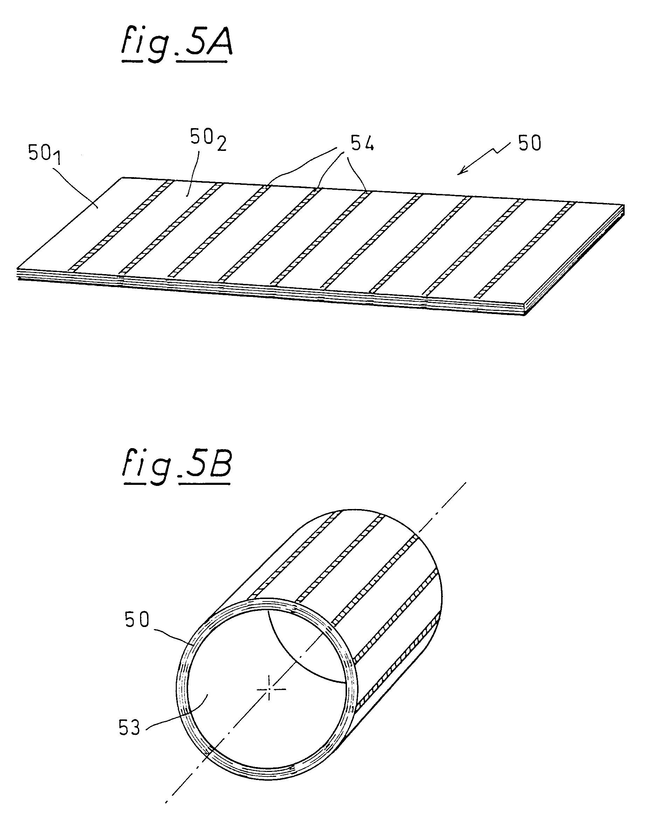

Les figures 5A et 5B illustrent encore une autre application du procédé selon l'invention.

Dans ce cas, plusieurs pièces sont réalisées à partir d'une même préforme fibreuse 50 constituée par un empilement de strates à plat. Des masques 54 sont disposés sur la préforme aux emplacements de lignes de séparation entre parties 50₁, 50₂, ... de la préforme correspondant aux différentes pièces à réaliser.

Dans l'exemple illustré, les pièces à réaliser ont la forme de secteurs de cylindre (portions de cylindre limitées par deux génératrices) ; il s'agit par exemple de volets de tuyère.

Après mise en place des masques 54, la préforme 50, maintenue à plat est soumise à une première phase d'infiltration en phase vapeur.

Après consolidation des parties de la préforme situées entre les masques 54, ces derniers sont retirés, laissant des liaisons souples entre les parties de préforme consolidées correspondant aux pièces à réaliser (figure 5A). La préforme 50 est alors placée et éventuel lement tendue sur un conformateur cylindrique ou mandrin 53. Les liaisons souples permettent à la préforme 50 d'épouser la forme du mandrin. Dans la mesure où la première consolidation est légère, la tension de la préforme 50 sur le mandrin peut amener une conformation des parties consolidées 50₁, 50₂, ... Le mandrin remplit ainsi une fonction d'outillage avec une structure beaucoup plus simple que celle des outillages traditionnels en graphite de type poinçon-matrice (figure 5B).

L'infiltration de la préforme 50 disposée sur le conformateur 53 est ensuite réalisée jusqu'à atteindre le degré de densification final souhaité. Les pièces obtenues sont alors séparées les unes des autres par découpe le long des lignes de séparation.

En variante, après une deuxième phase d'infiltration réalisant une consolidation plus poussée, la préforme peut être retirée du mandrin et l'infiltration est poursuivie après séparation des parties de préforme par découpe le long des lignes de séparation.

## Revendications

1. Procédé de fabrication d'une pièce en matériau composite comprenant l'élaboration d'une préforme fibreuse et la densification de la préforme par infiltration chimique en phase vapeur d'une matrice au sein de la porosité de la préforme, caractérisé en ce que l'on réalise sur la préforme un masquage le long de l'emplacement d'une ou de chacune de ligne(s) de pliage ou de séparation, afin de s'opposer à l'infiltration du matériau constitutif de la matrice dans la ou chaque zone masquée de la préforme, de sorte qu'après densification la ou chaque zone masquée de la préforme constitue une liaison souple intégrée à la préforme densifiée.

2. Procédé selon la revendication 1, caractérisé en ce que le masquage est réalisé au moyen de caches disposés de chaque côté de la préforme et munis de dents pénétrant dans la préforme afin de former une barrière vis-à-vis du flux gazeux utilisé lors de l'infiltration de la préforme.

3. Procédé selon la revendication 1, caractérisé en ce que le masquage est réalisé par dépôt sur la préforme d'un matériau susceptible d'être éliminé après infiltration de la préforme.

4. Procédé selon l'une quelconque des revendications 1 à 3, caractérisé en ce que le masquage de la préforme est conservé jusqu'à ce que le degré de densification final désiré soit atteint, de manière à obtenir, après suppression du masquage, une pièce en matériau composite avec une ou plusieurs liaison(s) souple(s) intégrée(s) constituant une ou plusieurs ligne(s) d'articulation.

5. Procédé selon l'une quelconque des revendications 1 à 3, caractérisé en ce que : le masquage de la préforme est conservé pendant une première phase de la densification de la préforme, au moins jusqu'à consolidation des parties de la préforme non masquées ; puis le masquage est supprimé de manière à obtenir une ou plusieurs liaisons souples intégrées dans la préforme consolidée ; la préforme est ensuite amenée à une forme correspondant à celle de la pièce à réaliser par pliage le long de ligne(s) correspondant à la (ou aux) liaison(s) souple(s) ; et la densification de la préforme est poursuivie, provoquant la rigidification de la (ou des) liaison(s) souple(s).

6. Procédé selon l'une quelconque des revendications 1 à 3, caractérisé en ce que, pour la fabrication de plusieurs pièces en matériau composite à partir d'une seule préforme, le masquage de la préforme est réalisé pour aménager des liaisons souples le long des lignes de séparation entre des parties de la préforme correspondant aux pièces à réaliser.

## Claims

1. Process for the manufacture of a composite material article, comprising the steps of making a fibrous preform and densifying said preform by chemical vapor infiltration of a matrix within the pores of said preform,
characterized in that a masking of said preform is carried out along the location of one or each one of folding or separation line or lines, in order to prevent the infiltration of the matrix material into the or each masked zone of said preform, whereby, after densification, the or each masked zone of the preform constitutes a flexible bond integrated to the densified preform.

2. Process according to claim 1, characterized in that the masking is obtained by means of maskers located on either side of the preform and fitted with teeth that penetrate into the preform so as to provide a barrier against the gaseous flux used during the infiltration of the preform.

3. Process according to claim 1, characterized in that the masking is obtained by depositing on the preform a material capable of being eliminated after infiltration of the preform.

4. Process according to any one of claims 1 to 3, characterized in that the masking of the preform is kept until a final required degree of densification is attained, so as to obtain, after elimination of the masking, a composite material component having one or more integrated flexible bond or bonds forming one or more articulation line or lines.

5. Process according to any one of claims 1 to 3, characterized in that the masking of the preform is retained during a first densification phase of the preform, lasting at least until the unmasked parts of the preform are consolidated, whereafter the masking is removed so as obtain one or more flexible bond or bonds integrated to the consolidated preform, the preform is thereafter brought into a shape corresponding to that of the component being manufactured by folding along line or lines corresponding to the flexible bond or bonds, and the densification of the preform is thereafter continued, thereby causing rigidification of the flexible bond or bonds.

6. Process according to any one of claims 1 to 3, characterized in that, for the manufacture of a plurality of composite material components from a single preform, the masking of said preform is effected to provide flexible bonds along the separation lines between parts of the preform corresponding to the articles to be manufactured.

## Patentansprüche

1. Verfahren zur Herstellung eines Verbundwerkstoffteils, bestehend aus der Herstellung eines faserigen Vorformlings und der Verdichtung des Vorformlings durch chemische Infiltration in der Dampfphase einer Matrix innerhalb der Porosität des Vorformlings,
**dadurch gekennzeichnet**, daß
auf dem Vorformling eine Abdeckung längs der Stelle einer bzw. jeder Falz- bzw. Trennlinie gebildet wird, um der Infiltration des Grundmaterials der Matrix in der bzw. in jeder abgedeckten Zone des Vorformlings derart entgegenzuwirken, daß nach der Verdichtung die bzw. jede abgedeckte Zone des Vorformlings eine nachgiebige, mit dem verdichteten Vorformling integrierte Verbindung bildet.

2. Verfahren nach Anspruch 1,
**dadurch gekennzeichnet**, daß
die Abdeckung mittels Masken durchgeführt wird, die auf jeder Seite des Vorformlings angeordnet werden und die mit in den Vorformling eindringenden Zähnen versehen sind, um gegen den bei der Infiltration des Vorformlings angewandten Gasstrom eine Barriere zu bilden.

3. Verfahren nach Anspruch 1,
**dadurch gekennzeichnet**, daß
die Abdeckung durch Ablagerung eines nach der Infiltration des Vorformlings beseitigbaren Materials auf den Vorformling erfolgt.

4. Verfahren nach einem der Ansprüche 1 - 3,
**dadurch gekennzeichnet**, daß
die Abdeckung des Vorformlings verbleibt, bis der gewünschte Endverdichtungsgrad erreicht ist, um nach dem Entfernen der Abdeckung ein Verbundstoffteil mit einer nachgiebigen integrierten Verbindung bzw. mehreren nachgiebigen integrierten Verbindungen zu erhalten, die eine Gelenklinie bzw. mehrere Gelenklinien bildet, bzw. bilden.

5. Verfahren nach einem der Ansprüche 1 - 3,
**dadurch gekennzeichnet**, daß
die Abdeckung des Vorformlings während einer ersten Phase der Verdichtung des Vorformlings wenigstens bis zur Verfestigung der nichtabgedeckten Teile des Vorformlings verbleibt, daß danach die Abdeckung derart entfernt wird, daR eine integrierte nachgiebige Verbindung bzw. mehrere integrierte nachgiebige Verbindungen im verfestigten Vorformling erhalten werden, daR der Vorformling dann in eine Form entsprechend derjenigen des durch Falten längs der Linie bzw. den Linien herzustellenden Teils entsprechend der nachgiebigen bzw. den nachgiebigen Verbindungen hergestellt wird, und daß der Vorformling verdichtet wird, so daß eine Verfestigung der nachgiebigen Verbindung bzw. der nachgiebigen Verbindungen bewirkt wird.

6. Verfahren nach einem der Ansprüche 1 - 3,
**dadurch gekennzeichnet**, daß
zur Herstellung mehrerer Verbundwerkstoffteile aus einem einzigen Vorformling die Abdeckung des Vorformlings durchgeführt wird, um die nachgiebigen Verbindungen längs Trennlinien zwischen Teilen des Vorformlings entsprechend den herzustellenden Teilen durchgeführt wird.
